# EUROPÄISCHE PATENTSCHRIFT

(11) **EP 1 798 857 B1**
(45) Veröffentlichungstag und Bekanntmachung des Hinweises auf die Patenterteilung: **02.09.2009**
(21) Anmeldenummer: 06024080.1
(22) Anmeldetag: 21.11.2006
(51) Int. Cl.: H03K 17/725, H02M 5/257, H05B 37/02

(54) **Elektronikschaltung zum Dimmen von Wechselströmen unter Einsatz eines Triacs**
Electronic circuit for dimming alternating currents with a Triac
Circuit électronique de variation d'alternances de l'intensité du courant alternatif en utilisant un Triac

(30) Priorität: 17.12.2005 DE 102005060584; 07.04.2006 DE 102006016392
(43) Veröffentlichungstag der Anmeldung: 20.06.2007
(73) Patentinhaber: ABB AG, 68309 Mannheim (DE)
(72) Erfinder: Rümenapf, Peter, Dipl.-Ing., 58579 Schalksmühle (DE); Klett, Martin, Dipl.-Ing., 44141 Dortmund (DE)
(74) Vertreter: Miller, Toivo

(56) Entgegenhaltungen:
- DE-A1- 3 041 840
- DE-A1- 3 311 425
- DE-A1- 19 837 608
- GB-A- 2 330 704
- JP-A- 7 111 776
- JP-A- 2000 068 075
- US-A1- 4 274 045
- US-A1- 4 366 426

## Beschreibung

Die Erfindung bezieht sich auf eine Elektronikschaltung zum Dimmen von Wechselströmen unter Einsatz eines Triacs

Aus der EP 0 321 798 B1 ist eine Schaltungsanordnung zur Steuerung eines Leistungstriacs bekannt, der in Reihe zu einer vom Netz gespeisten Last liegt und diese in Abhängigkeit von der Schaltstellung eines Steuerschalters an Spannung legt, wobei der Steuerschalter über eine Ansteuerschaltung so auf das Gate des Leistungstriacs wirkt, dass vor jedem Durchschalten seiner Schaltstrecke ein Restphasenanschnitt verbleibt und hierzu ein RC-Glied mit einem Zündkondensator den Zündstrom für den Leistungstriac über eine Triggerdiode an das Gate des Leistungstriacs liefert. Eine Gleichrichter-Brückenschaltung liegt mit ihren Wechselspannungseingängen in dem Stromzweig zwischen dem Zündkondensator und dem Gate des Leistungstriacs. Der Stromzweig zwischen den Gleichspannungsausgängen der Brückenschaltung ist durch einen steuerbaren, im Diagonalzweig der Brückenschaltung liegenden Halbleiterschalter geschlossen, dessen Gate ausgehend vom Steuerschalter gesteuert ist: Zwischen dem Gate des Halbleiterschalters und dem Steuerschalter liegt eine Treiberschaltung, die von einer Versorgungsschaltung gespeist ist.

Ein erstes allgemein bekanntes Verfahren zur Ansteuerung eines Triacs besteht in einer impulsartigen Gate-Ansteuerung des Triacs, zeitlich synchronisiert mit der zu schaltenden Wechselspannung. Dabei ist allerdings bei kritischen Lastbedingungen, bei denen zum gewünschten Zündzeitpunkt der Haltestrom nicht erreicht wird bzw. kurz nach der Zündung wieder unterschritten wird, eine kontrollierte Nachzündung durch zusätzliche Zündimpulse notwendig. Nachteilig sind dabei der erforderliche Schaltungsaufwand, der erhöhte Energiebedarf für Mehrfachzündungen und die erhöhten Funkstörwerte bei leistungsstarken Anwendungen.

Ein zweites allgemein bekanntes Verfahren zur Ansteuerung eines Triacs besteht in einer dauernden bzw. für einen erheblichen Teil der Wechselstromperiode (respektive Netzhalbwelle) andauernden Gate-Ansteuerung des Triacs. Dabei ist die aufwendige Bereitstellung der notwendigen Energie zur Aufrechterhaltung des Triac-Gatestroms von Nachteil. Bei einer typischen "2-Draht-Schaltung", bei welcher die Triac-Halbleiterschaltung in Reihe zur Last geschaltet ist und die Triac-Halbleiterschaltung keine direkte Schaltungsverbindung zum Nulleiter hat, kann mit herkömmlichen Netzteilschaltungen der notwendige Energiebedarf nicht abgedeckt werden.

Der Erfindung liegt die Aufgabe zugrunde, eine Elektronikschaltung zum Dimmen von Wechselströmen unter Einsatz eines Triacs anzugeben, welche einerseits eine dauernde bzw. für einen erheblichen Teil der Wechselstromperiode (respektive Netzhalbwelle) andauernden Gate-Ansteuerung des Triacs ermöglicht und andererseits auch für die Anwendung bei "2-Draht-Schaltungen" geeignet ist.

Diese Aufgabe wird erfindungsgemäß durch die im Anspruch 1 angegebenen Merkmale gelöst.

Die mit der Erfindung erzielbaren Vorteile bestehen insbesondere darin, dass der relativ hohe Zündstrom für den Triac direkt aus dem speisenden Wechselspannungsnetz erzeugt wird, während der relativ geringe Energiebedarf für die Steuerelektronik (Kontrolleinheit) durch ein Netzteil bereitgestellt wird. Die vorgeschlagene Elektronikschaltung zum Dimmen von Wechselströmen unter Einsatz eines Triacs ist sowohl für ohmsche Lasten als auch für induktive Lasten als auch für kapazitive Lasten einsetzbar.

Weitere Vorteile sind aus der nachstehenden Beschreibung ersichtlich.

Vorteilhafte Ausgestaltungen der Erfindung sind in den abhängigen Ansprüchen gekennzeichnet.

Die Erfindung wird nachstehend anhand der in der Zeichnung dargestellten Ausführungsbeispiele erläutert. Es zeigen:
- Fig.1: ein schematisches Schaltbild einer Elektronikschaltung zum Dimmen von Wechselströmen unter Einsatz eines Triacs,
- Fig. 2: den zur Ladung eines Speicherkondensators eines Netzteils fließenden Strom,
- Fig. 3: den zur Ansteuerung des Triacs fließenden Strom,
- Fig. 4: die bei eingeschaltetem Triac fließenden Ströme,
- Fig. 5 - 7: die für unterschiedliche Betriebsarten interessierenden Zeitabschnitte,
- Fig. 8 - 9: eine erfindungsgemäße Ausführungsform des Umschalters sowie einen interessierender Zeitabschnitt für eine mögliche Betriebsart.

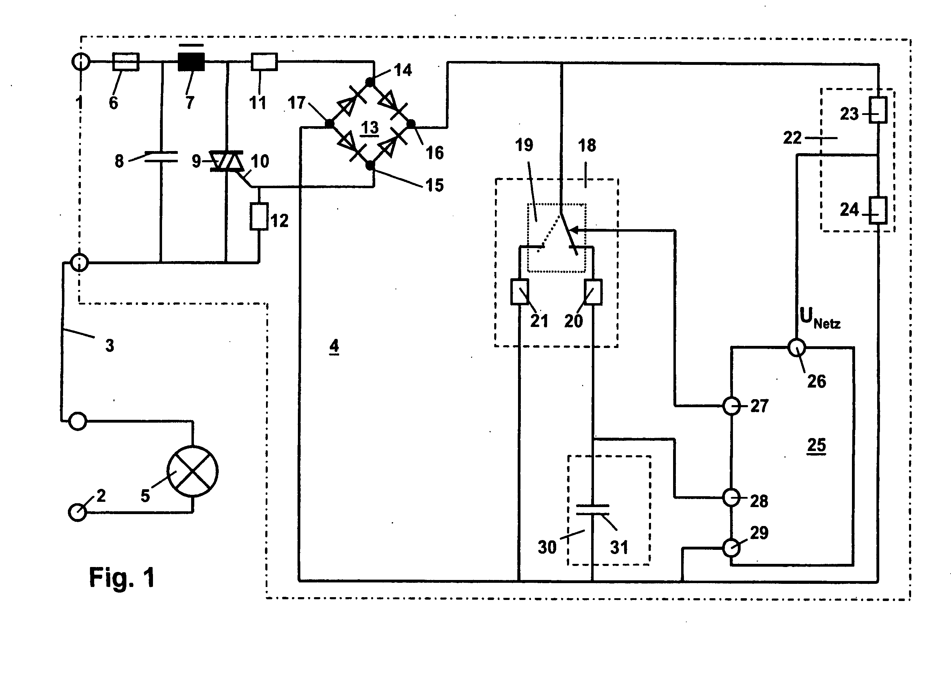

In Fig. 1 ist ein schematisches Schaltbild einer Elektronikschaltung zum Dimmen von Wechselströmen unter Einsatz eines Triacs dargestellt. Die Elektronikschaltung 4 (zum Dimmen von Wechselströmen unter Einsatz eines Triacs) ist eingangsseitig an einen Netzphasenleiter (L) 1 eines Wechselspannungsnetzes angeschlossen und ist ausgangsseitig über eine geschaltete Netzphasenleitung 3 mit einer Last 5, z. B. einer Leuchte verbunden. Die Last 5 ist andererseits an einen Nulleiter (N) dieses Wechselspannungsnetzes angeschlossen. Wie ersichtlich, genügen zwei Drähte zum Anschluss der Elektronikschaltung 4, d. h. es liegt typischerweise eine "2-Draht-Schaltung" vor, bei welcher keine direkte Verbindung zwischen der Elektronikschaltung und dem Nulleiter besteht.

Der Netzphasenleiter 1 wird über eine Sicherung 6, eine Drossel 7 und einen Vorwiderstand 11 zum ersten Wechselspannungsanschluss 14 eines Brückengleichrichters 13 geführt. Ein Kondensator 8 ist zwischen dem Verbindungspunkt zwischen Sicherung 6 und Drossel 7 einerseits sowie dem Anschluss an die geschaltete Netzphasenleitung 3 andererseits geschaltet. Ein Triac 9 ist zwischen dem Verbindungspunkt zwischen Drossel 7 und Vorwiderstand 11 einerseits sowie dem Anschluss an die geschaltete Netzphasenleitung 3 geschaltet. Der zweite Wechselspannungsanschluss 15 des Brückengleichrichters 13 ist mit dem Steueranschluss (Gate) 10 des Triacs 9 und mit einem Gate-Widerstand 12 verbunden, welcher anderseits am Anschluss an die geschaltete Netzphasenleitung 3 liegt.

Der positive Gleichspannungsanschluss 16 des Brückengleichrichters 13 ist mit dem Eingang eines Umschalters 19 einer Stromsteuerung 18 sowie mit einem Widerstand 23 einer Synchronisiereinheit 22 verbunden. Der Umschalter 19 weist zwei Ausgänge auf, wobei der erste Ausgang über einen Lade-Vorwiderstand 20 an einen Speicherkondensator 31 eines Netzteils 30 und der zweite Ausgang über einen Zünd-Vorwiderstand 21 an den negativen Gleichspannungsanschluss 17 des Brückengleichrichters 13 angeschlossen ist. Der weitere Anschluss des Speicherkondensators 31 liegt ebenfalls am negativen Gleichspannungsanschluss 17. Der Widerstand 23 ist andererseits über einen weiteren Widerstand 24 an den negativen Gleichspannungsanschluss 17 angeschlossen.

Zum Schalten/Dimmen der Last ist eine Kontrolleinheit (Steuerelektronik) 25 vorgesehen,
- welche einen Synchronisierungs-Eingang 26 aufweist, der an den gemeinsamen Verbindungspunkt beider Widerstände 23, 24 der Synchronisiereinheit 22 angeschlossen ist und ein Synchronisier-Signal U_{Netz} erhält, welches ein Abbild der zwischen Netzphasenleiter 1 und Nulleiter 2 anliegenden Spannung des Wechselspannungsnetzes ist,
- welche einen Stromsteuerungs-Ausgang 27 zur Ansteuerung des Umschalters 19 der Stromsteuerung 18 aufweist,
- welche einen positiven Versorgungsspannungs-Anschluss 28 und einen negativen Versorgungsspannungs-Anschluss 29 aufweist, wobei diese beiden Anschlüsse 28, 29 mit dem Netzteil 30 respektive mit den beiden Klemmen des Speicherkondensators 31 verbunden sind.

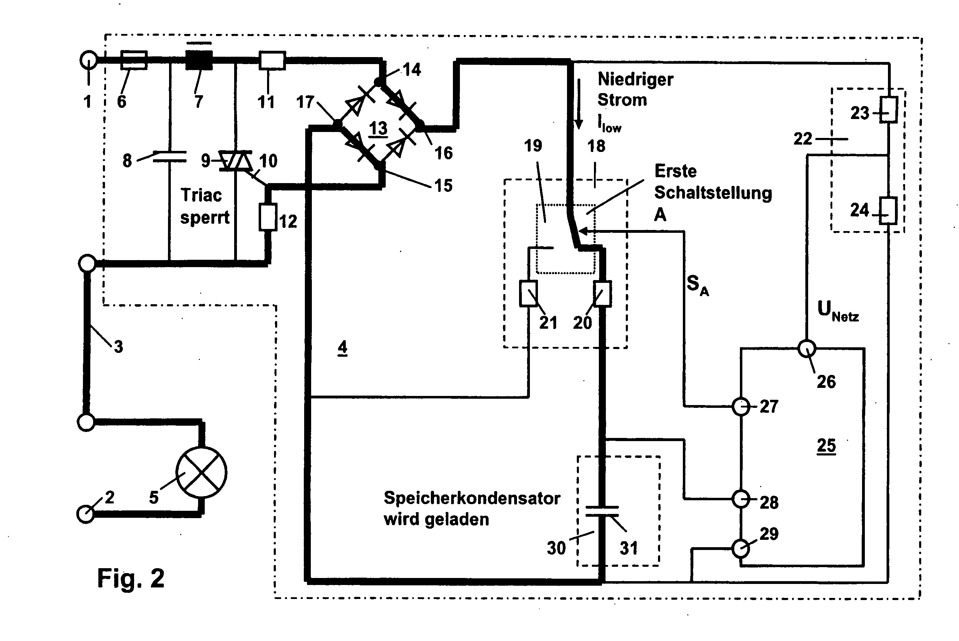

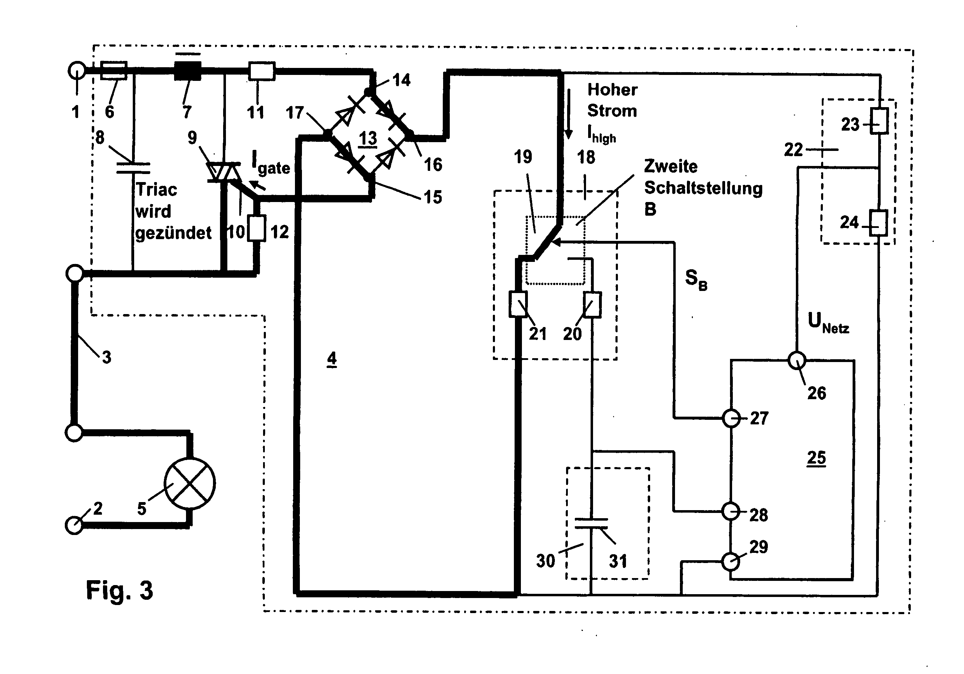

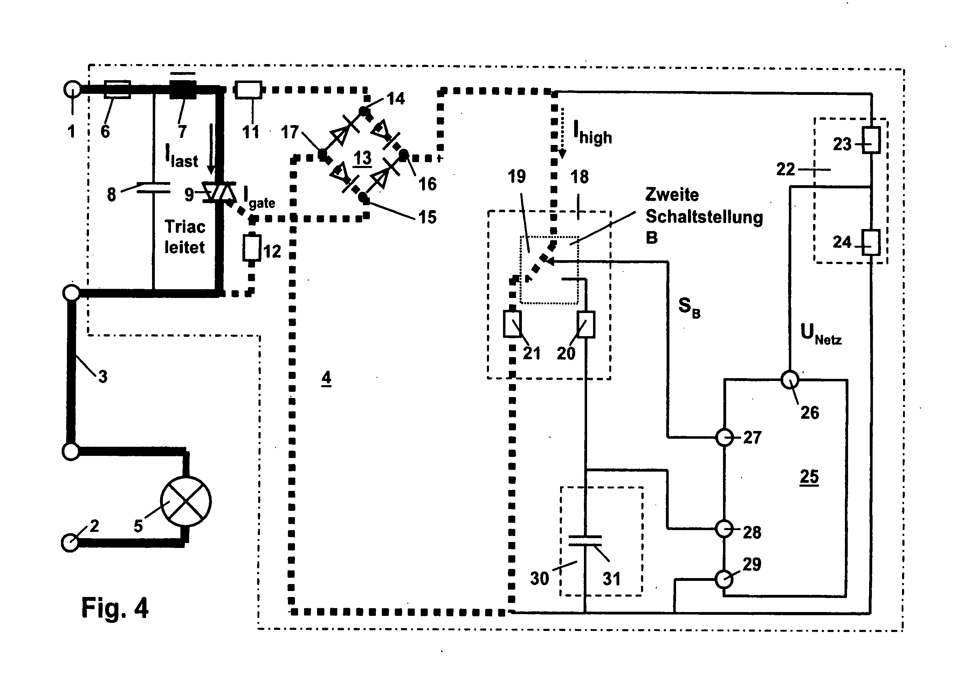

Durch entsprechende Ansteuerung des Umschalters 19 während unterschiedlicher, auf die Spannung des Wechselspannungsnetzes bezogener Zeitabschnitte T_{A} und T_{B} ergeben sich in einer netzsynchronen zeitlichen Abfolge unterschiedliche Stromflüsse, und zwar
- ergibt sich während eines Lade-Zeitabschnittes T_{A} bei sperrendem Triac ein niedriger Ladestrom I_{low} für das die Steuerelektronik (= Kontrolleinheit 25) versorgende Netzteil 30: siehe den in Fig. 2 gezeigten Stromfluss I_{low} zur Ladung des Speicherkondensators 31,
- wird bei einzuschaltender Last während eines Dimm-Zeitabschnittes T_{B} ein ausreichend hoher Strom I_{gate} direkt aus dem Laststromkreis über das Gate (Steueranschluss) des Triacs in die Last geführt, welcher den Triac zündet bzw. im leitenden Zustand hält: siehe die in Fig. 3 gezeigte Stromflüsse I_{high} und I_{gate},
- ergeben sich folglich während der Leitphasen des Triacs die in Fig. 4 gezeigten Stromflüsse I_{high}, I_{gate} und Iₗₐₛₜ,
- entfallen diese vorstehend für den Dimm-Zeitabschnitt T_{B} erwähnten Stromflüsse I_{high}, I_{gate} und Iₗₐₛₜ, wenn die Last nicht einzuschalten ist,
- beginnen diese vorstehend für den Dimm- Zeitabschnitt T_{B} erwähnten Stromflüsse I_{high}, I_{gate} und Iₗₐₛₜ verzögert bezüglich der Netzhalbwelle, wenn die Last nicht zu schalten, sondern zu dimmen ist.

In Fig. 2 ist der zur Ladung des Speicherkondensators 31 des Netzteils 30 fließende Strom I_{low} dargestellt. Sobald die Kontrolleinheit (Steuerelektronik) 25 mittels des Synchronisier-Signals U_{Netz} einen Nulldurchgang der Spannung des Wechselspannungsnetzes (anliegend zwischen Netzphasenleiter 1 und Nulleiter 2) detektiert, beaufschlagt sie den Stromsteuerungs-Ausgang 27 mit dem Ansteuersignal S_{A}, wodurch bewirkt wird, dass der Umschalter 19 die in Fig. 2 gezeigte Lade-Schaltstellung A einnimmt. Es ergibt sich ein Stromfluss I_{low} Netzphasenleiter 1 - Sicherung 6 - Drossel 7 - Vorwiderstand 11 - erster Wechselspannungsanschluss 14 - positiver Gleichspannungsanschluss 16 - Umschalter 19 - Lade-Vorwiderstand 20 - Speicherkondensator 31 - negativer Gleichspannungsanschluss 17 - zweiter Wechselspannungsanschluss 15 - Gate-Widerstand 12 - geschaltete Netzphasenleitung 3 - Last 5 - Nulleiter 2. Der Stromfluss I_{low} ist in Abstimmung mit dem Lade-Vorwiderstand 20 und dem Gate-Widerstand 12 gerade so hoch bemessen, dass die Einschaltschwelle des Triacs 9 nicht erreicht wird, d. h. der Triac verbleibt im sperrenden Zustand.

In Fig. 3 ist der zur Ansteuerung des Triacs fließende Strom dargestellt. Wenn die Last 5 einzuschalten ist und die Kontrolleinheit 25 mittels des Synchronisier-Signals U_{Netz} eine Spannung des Wechselspannungsnetzes detektiert, welche über einem vorgegebenen Schwellenspannungswert ±U_{Schwell} liegt, wird der Stromsteuerungs-Ausgang 27 mit dem Ansteuersignal S_{B} beaufschlagt, wodurch bewirkt wird, dass der Umschalter 19 die in Fig. 3 gezeigte Dimm-Schaltstellung B einnimmt. Es ergibt sich ein Stromfluss I_{high} Netzphasenleiter 1 - Sicherung 6 - Drossel 7 - Vorwiderstand 11 - erster Wechselspannungsanschluss 14 - positiver Gleichspannungsanschluss 16 - Umschalter 19 - Zünd-Vorwiderstand 21 - negativer Gleichspannungsanschluss 17 - zweiter Wechselspannungsanschluss 15 - Gate-Widerstand 12 - geschaltete Netzphasenleitung 3 - Last 5 - Nulleiter 2. Der Stromfluss I_{high} ist in Abstimmung mit dem Zünd-Vorwiderstand 21 und dem Gate-Widerstand 12 so hoch bemessen, das die Einschaltschwelle des Triacs 9 zumindest erreicht, vorzugsweise überschritten wird. Es fließt ein Gate-Strom I_{gate} vom zweiten Wechselspannungsanschluss 15 in den Steueranschluss 10 des Triacs 9, wodurch eine Durchzündung des Triacs bewirkt wird.

Das Ansteuersignal S_{B} wird eine ausreichende Zeit während der Netzhalbwelle beibehalten. Dies hat folgende Gründe:
- Kann der notwendige Haltestrom des Triacs 9 zum Zündbeginn noch nicht erreicht werden, erfolgt die tatsächliche Zündung des Triacs automatisch zu einem geringfügig späteren Zeitpunkt innerhalb der betrachteten Netzhalbwelle, sobald die Spannung über dem Triac 9 ausreichend hoch ist.
- Wird der Haltestrom während der minimal erforderlichen Zünddauer unterschritten, erfolgt automatisch ein Nachzünden, sobald die Spannung über dem Triac 9 ausreichend hoch ist.

In Fig. 4 sind die bei eingeschaltetem Triac fließenden Ströme dargestellt. Vorauszusetzen ist, dass das Ansteuersignal S_{B} vorliegt und der Umschalter 19 folglich die Dimm-Schaltstellung B einnimmt. Es ergeben sich die unter Fig. 3 erläuterten Stromflüsse I_{high} und I_{gate}. Zusätzlich fließt ein Laststrom Iₗₐₛₜ Netzphasenleiter 1 - Sicherung 6 - Entstördrossel 7 - Triac 9 - geschaltete Netzphasenleitung 3 - Last 5 - Nulleiter 2.

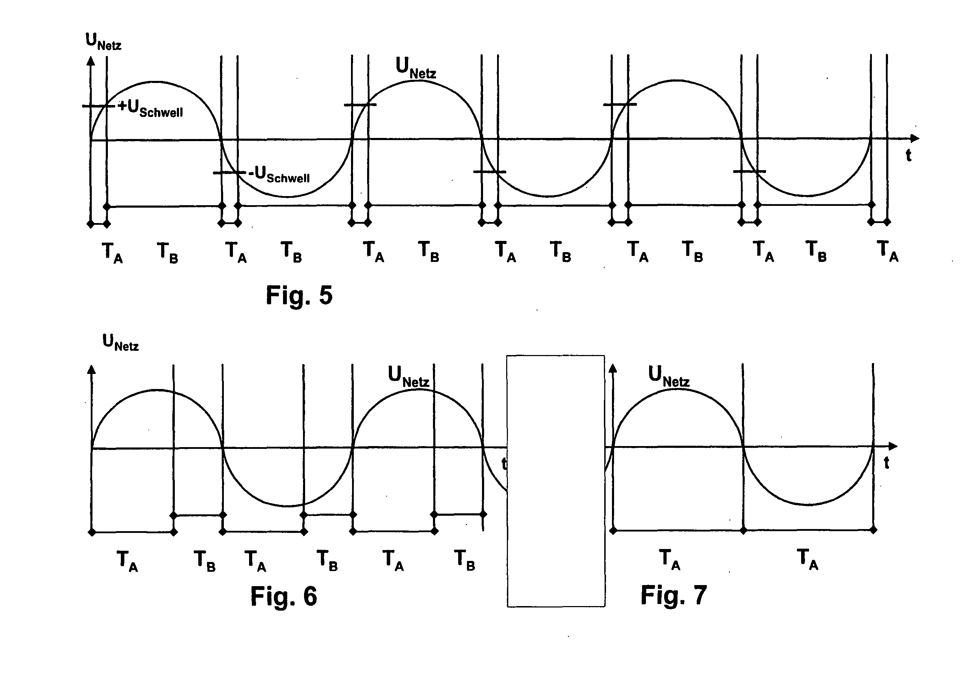

In den Fig. 5 - 7 sind die für unterschiedliche Betriebsarten interessierende Zeitabschnitte dargestellt:
- Fig. 5 zeigt die Betriebsart, welche bei einer einzuschaltenden Last 5 vorliegt. Es wechseln sich netzsynchron je Netzhalbwelle die Zeitabschnitte T_{A} und T_{B} ab. Der Zeitabschnitt T_{A} liegt unmittelbar nach jedem Nulldurchgang der Netzhalbwelle vor, sobald für das Synchronisiersignal gilt: 0 < U_{Netz} < +U_{Schwell} respektive 0 < U_{Netz} < -U_{Schwell}.
- Fig. 6 zeigt die Betriebsart, welche bei einer zu dimmenden Last 5 vorliegt. Im Vergleich zur Betriebsart gemäß Fig. 5 kann der Zeitabschnitt T_{A} vergrößert werden. Das Ende des Zeitabschnitts T_{A} wird automatisch durch den Beginn des Zeitabschnitts T_{B} festgelegt, welcher entsprechend dem für das Dimmen einzustellenden Phasenanschnitt vorgegeben ist.
- Fig. 7 zeigt die Betriebsart, welche vorliegt, wenn die Last 5 nicht einzuschalten bzw. nicht zu dimmen ist. Bei dieser Betriebsart kann sich der Zeitabschnitt T_{A} über die gesamte Netzhalbwelle erstrecken.

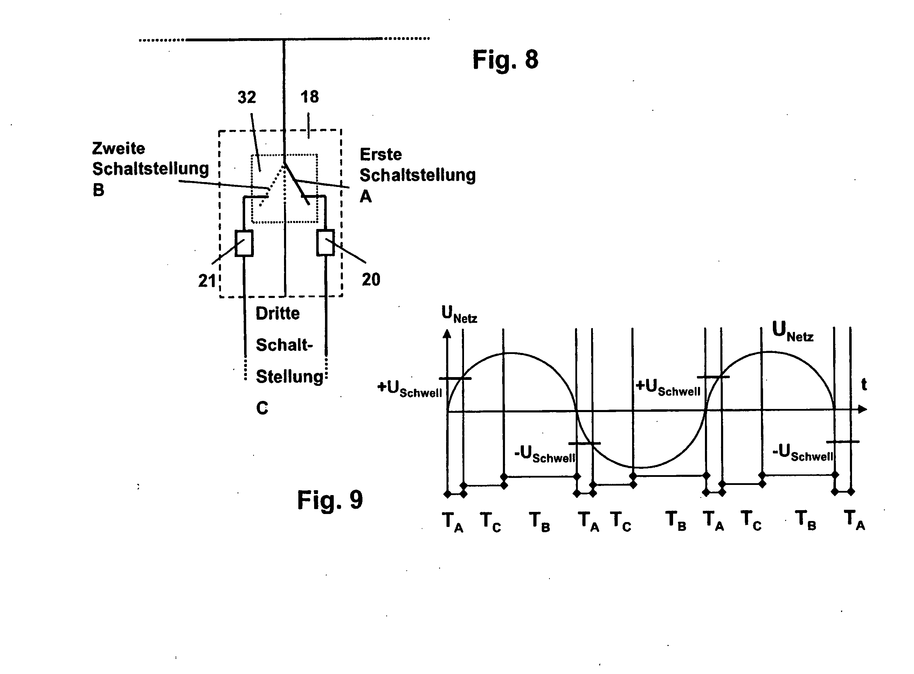

In den Fig. 8 - 9 sind eine erfindungsgemäße Ausführungsform des Umschalters sowie ein interessierender Zeitabschnitt für eine mögliche Betriebsart für eine zu dimmende Last hierzu gezeigt. Bei dieser Ausführungsform wird für die Stromsteuerung 18 ein Umschalter 32 eingesetzt, der außer der Lade-Schaltstellung A während der Zeitabschnitte T_{A} (mit Stromfluss über Lade-Vorwiderstand 20 wie vorstehend beschrieben) und der Dimm-Schaltstellung B während der Zeitabschnitte T_{B} (mit Stromfluss über Zünd-Vorwiderstand 21 wie vorstehend beschrieben) eine neutrale Mittelstellung respektive Neutral-Schaltstellung C während der Neutral-Zeitabschnitte T_{C} einnehmen kann. In dieser Neutral-Schaltstellung C des Umschalters 32 werden keine Stromkreise geschlossen.

Eine mögliche Betriebsart hierzu ist in Fig. 9 dargestellt. Es wechseln sich netzsynchron je Netzhalbwelle die Zeitabschnitte T_{A}, T_{C} und T_{B} ab. Der Lade-Zeitabschnitt T_{A} liegt nach jedem Nulldurchgang der Netzhalbwelle vor, sobald für das Synchronisiersignal gilt: 0 < U_{Netz} < +U_{Schwell} respektive 0 < U_{Netz} < -U_{Schwell}. Es schließt sich der Neutral-Zeitabschnitt T_{C} an. Das Ende des Neutral-Zeitabschnitts T_{C} wird automatisch durch den Beginn des Dimm-Zeitabschnitts T_{B} festgelegt, welcher entsprechend dem für das Dimmen einzustellenden Phasenanschnitt vorgegeben ist.

Für alle Ausführungsformen gilt, dass die Länge des Lade-Zeitabschnittes T_{A} derart bemessen ist, dass der während dieses Zeitabschnittes fließende Strom I_{low} ausreichend hoch ist, um den zur Energieversorgung der Kontrolleinheit 25 dienenden Speicherkondensator 31 ausreichend aufzuladen.

Für alle Ausführungsformen gilt auch, dass der Lade-Zeitabschnitt T_{A} alternativ auch an das Ende jeder Netzhalbwelle (kurz vor jedem Nulldurchgang der Netzhalbwelle) gelegt werden kann.

Auch wenn vorstehend eine Leuchte als Last 5 verwendet wird, ist die Elektronikschaltung zum Dimmen von Wechselströmen unter Einsatz eines Triacs sowohl für ohmsche Lasten als auch für induktive Lasten als auch für kapazitive Lasten vorteilhaft einsetzbar.

### Bezugszeichenliste

- 1: Netzphasenleiter (L) eines Wechselspannungsnetzes
- 2: Nulleiter (N) eines Wechselspannungsnetzes
- 3: geschaltete Netzphasenleitung
- 4: Elektronikschaltung zum Dimmen von Wechselströmen unter Einsatz eines Triacs
- 5: Last (beispielsweise Leuchte)
- 6: Sicherung
- 7: Drossel
- 8: Kondensator
- 9: Triac
- 10: Steueranschluss des Triacs
- 11: Vorwiderstand
- 12: Gate-Widerstand
- 13: Brückengleichrichter
- 14: erster Wechselspannungsanschluss
- 15: zweiter Wechselspannungsanschluss
- 16: positiver Gleichspannungsanschluss
- 17: negativer Gleichspannungsanschluss
- 18: Stromsteuerung
- 19: Umschalter
- 20: Lade-Vorwiderstand
- 21: Zünd-Vorwiderstand
- 22: Synchronisiereinheit
- 23: Widerstand
- 24: Widerstand
- 25: Kontrolleinheit (Steuerelektronik)
- 26: Synchronisierungs-Eingang
- 27: Stromsteuerungs-Ausgang
- 28: positiver Versorgungsspannungs-Anschluss
- 29: negativer Versorgungsspannungs-Anschluss
- 30: Netzteil
- 31: Speicherkondensator
- 32: Umschalter
- A: Lade-Schaltstellung
- B: Schalt/Dimm-Schaltstellung
- C: Neutral-Schaltstellung
- T_{A}: Lade-Zeitabschnitt einer jeden Netzhalbwelle
- T_{B}: Schalt/Dimm-Zeitabschnitt
- T_{C}: Neutral-Zeitabschnitt
- S_{A}: Ansteuersignal
- S_{B}: Ansteuersignal
- t: Zeit
- U_{Netz}: Synchronisiersignal entspr. der Spannung des Wechselspannungsnetzes
- ±U_{Schwell}: Schwellspannungswert
- Iₗₐₛₜ: Laststrom des Triacs
- I_{gate}: Gatestrom des Triacs
- I_{low}: Ladestrom des Speicherkondensators
- I_{high}: Strom zur Zündung des Triacs

## Patentansprüche

1. Elektronikschaltung zum Dimmen von Wechselströmen unter Einsatz eines Triacs (9), wobei der Triac (9) mit seinem ersten Hauptanschluss über einer Drossel (7) am Netzphasenleiter (1) eines Wechselspannungsnetzes und mit seinem zweiten Hauptanschluss über einer Last (5) am Nulleiter (2) des Wechselspannungsnetzes liegt und ein Brückengleichrichter (13) vorgesehen ist, dessen erster Wechselspannungsanschluss (14) über einem Vorwiderstand (11) an den Verbindungspunkt von Drossel (7) und Triac (9) und dessen zweiter Wechselspannungsanschluss (15) am Steueranschluss (10) des Triacs (9) sowie über einen Gate-Widerstand (12) an den Verbindungspunkt von Triac (9) und Last (5) angeschlossen ist,
- wobei eine Stromsteuerung (18) mit einem mindestens eine Lade-Schaltstellung und eine Dimm-Schaltstellung (A, B) einnehmenden Umschalter (19, 32) vorgesehen ist,
- wobei in der Lade-Schaltstellung (A) der positive Gleichspannungsanschluss (16) des Brückengleichrichters (13) über einen Lade-Vorwiderstand (20) und einen Speicherkondensator (31) mit dem negativen Gleichspannungsanschluss (17) des Brückengleichrichters (13) verbunden ist,
- wobei in der Dimm-Schaltstellung (B) der positive Gleichspannungsanschluss (16) des Brückengleichrichters (13) über einen Zünd-Vorwiderstand (21) mit dem negativen Gleichspannungsanschluss (17) des Brückengleichrichters (13) verbunden ist,
- wobei die Ansteuerung des Umschalters (19, 32) über eine Kontrolleinheit (25) erfolgt, wobei der Umschalter (19, 32) während eines vorgegebenen Lade-Zeitabschnitts (T_{A}) jeder Netzhalbwelle in die Lade-Schaltstellung (A) gebracht wird,
- wobei der Speicherkondensator (31) die Kontrolleinheit (25) versorgt
- und wobei der Umschalter (32) außer der Lade-Schaltstellung (A) und der Dimm-Schaltstellung (B) eine Neutral-Schaltstellung (C) einnehmen kann, in welcher kein Stromkreis zwischen den Gleichspannungsanschlüssen (16, 17) des Brückengleichrichters (13) geschlossen wird.

2. Elektronikschaltung nach Anspruch 1, **dadurch gekennzeichnet, dass** die Kontrolleinheit (25) von einer zwischen den Gleichspannungsanschlüssen (16, 17) des Brückengleichrichters (13) geschalteten Synchronisiereinheit (22) ein Synchronisiersignal (U_{Netz}) entsprechend der aktuellen Spannung des Wechselspannungsnetzes empfängt.

3. Elektronikschaltung nach Anspruch 2, **dadurch gekennzeichnet, dass** die Synchronisiereinheit (22) aus zwei in Reihe geschalteten Widerständen (23, 24) gebildet ist, deren Verbindungspunkt am Synchronisierungs-Eingang (26) der Kontrolleinheit (25) liegt, um derart den vorgegebenen Lade-Zeitabschnitt (T_{A}) jeder Netzhalbwelle zu detektieren.

4. Elektronikschaltung nach einem der vorstehenden Ansprüche, **dadurch gekennzeichnet, dass** der Lade-Zeitabschnitt T_{A} unmittelbar nach jedem Nulldurchgang der Netzhalbwelle vorliegt.

5. Elektronikschaltung nach einem der Ansprüche 1-3, **dadurch gekennzeichnet, dass** der Lade-Zeitabschnitt T_{A} kurz vor jedem Nulldurchgang der Netzhalbwelle vorliegt.

## Claims

1. An electronic circuit for dimming alternating currents by using a triac (9), with the triac (9) being connected with its first main terminal via a throttle (7) to the network phase conductor (1) of an AC voltage network and with its second main terminal via a load (5) to the neutral conductor (2) of the AC voltage network, and a bridge rectifier (13) is provided whose first alternating voltage terminal (14) is connected via a series resistor (11) to the connection point of throttle (7) and triac (9) and whose second alternating voltage terminal (15) is connected to the control terminal (10) of the triac (9) and via a gate resistor (12) to the connection point of triac (9) and load (5),
- with a current controller (18) with a changeover switch (19, 32) that engages at least one load-switching position and a dimming switching position (A,B);
- with the positive direct voltage terminal (16) of the bridge rectifier (13) being connected in the load-switching position (A) via a load-series resistor (20) and a storage capacitor (31) with the negative direct voltage terminal (17) of the bridge rectifier (13);
- with the positive direct voltage terminal (16) of the bridge rectifier (13) being connected in the dimming switching position (B) via an ignite-series resistor (21) with the negative direct voltage terminal (17) of the bridge rectifier (13);
- with the triggering of the changeover switch (19, 32) occurring via a control unit (25), with the changeover switch (19, 32) being brought into the load-switching position (A) during a predetermined load time period (T_{A}) of each network half-cycle;
- with the storage capacitor (31) supplying the control unit (25);
- and with the changeover switch (32) also being able to assume a neutral switching position (C) in addition to the load-switching position (A) and the dimming switching position (B) in which no electric circuit is closed between the direct voltage terminals (16, 17) of the bridge rectifier (13).

2. An electronic circuit according to claim 1, **characterized in that** the control unit (25) receives a synchronization signal (U_{Netz}) according to the current voltage of the AC voltage network from a synchronization unit (22) switched between the direct voltage terminals (16, 17) of the bridge rectifier (13).

3. An electronic circuit according to claim 2, **characterized in that** the synchronization unit (22) is formed by two resistors (23, 24) which are switched in series and whose connection point lies at the synchronization input (26) of the control unit (25) in order to thus detect the predetermined load time period (T_{A}) of each network half-cycle.

4. An electronic circuit according to one of the preceding claims, **characterized in that** the load time period (T_{A}) is present after each zero crossing of the network half-cycle.

5. An electronic circuit according to one of the claims 1 to 3, **characterized in that** the load time period (T_{A}) is present shortly before each zero crossing of the network half-cycle.

## Revendications

1. Circuit électronique pour l'atténuation de courants alternatifs à l'aide d'un triac (9), lequel triac (9) est connecté par son premier raccord principal, par l'intermédiaire d'une self (7), au conducteur de phase du réseau (1) d'un réseau de courant alternatif et par son deuxième raccord principal, par l'intermédiaire d'une résistance fixe (5), au conducteur neutre (2) du circuit de courant alternatif et il est prévu un redresseur à pont (13) dont le premier raccord de courant alternatif (14) est connecté par l'intermédiaire d'une résistance série (11) au point de connexion de la self (7) et du triac (9) et dont le deuxième raccord de courant alternatif (15) est connecté au raccord de commande (10) du triac (9) et, par l'intermédiaire d'une résistance de grille (12), au point de connexion du triac (9) et de la résistance fixe (5),
- dans lequel une commande d'intensité (18) avec un commutateur (19, 32) prenant au moins une position de commutation de charge et une position de commutation d'atténuation (A, B) est prévue,
- dans lequel, dans la position de commutation de charge (A), le raccord de courant continu positif (16) du redresseur à pont (13) est connecté par l'intermédiaire d'une résistance série de charge (20) et d'un condensateur d'accumulation (31) au raccord de courant continu négatif (17) du redresseur à pont (13),
- dans lequel, dans la position de commutation d'atténuation (B), le raccord de courant continu positif (16) du redresseur à pont (13) est relié par l'intermédiaire d'une résistance série d'allumage (21) au raccord de courant continu négatif (17) du redresseur à pont (13),
- dans lequel l'activation du commutateur (19, 32) est réalisé par une unité de contrôle (25), le commutateur (19, 32) étant amené dans la position de charge (A) pendant un intervalle de temps de charge (T_{A}) prédéterminé de chaque demi-onde du réseau,
- dans lequel le condensateur d'accumulation (31) alimente l'unité de contrôle (25),
- et dans lequel le commutateur (32) peut prendre, outre la position de commutation de charge (A) et la position de commutation d'atténuation (B), une position de commutation neutre (C), dans laquelle aucun circuit électrique n'est fermé entre les raccords de courant continu (16, 17) du redresseur à pont (13).

2. Circuit électronique selon la revendication 1, **caractérisé en ce que** l'unité de contrôle (25) reçoit d'une unité de synchronisation (22) montée entre les raccords de courant continu (16, 17) du redresseur à pont (13) un signal de synchronisation (U_{réseau}) correspondant à la tension actuelle du circuit de courant alternatif.

3. Circuit électronique selon la revendication 2, **caractérisé en ce que** l'unité de synchronisation (22) est formée de deux résistances (23, 24) montées en série, dont le point de connexion se trouve sur l'entrée de synchronisation (26) de l'unité de contrôle (25), pour détecter ainsi l'intervalle de temps de charge (T_{A}) prédéterminé de chaque demi-onde du réseau.

4. Circuit électronique selon l'une des revendications précédentes, **caractérisé en ce que** l'intervalle de temps de charge (T_{A}) se trouve immédiatement après chaque passage à zéro de la demi-onde du réseau.

5. Circuit électronique selon l'une des revendications 1 à 3, **caractérisé en ce que** l'intervalle de temps de charge (T_{A}) se trouve peu avant chaque passage à zéro de la demi-onde du réseau.
